# EUROPÄISCHE PATENTSCHRIFT

(11) **EP 2 583 318 B1**
(45) Veröffentlichungstag und Bekanntmachung des Hinweises auf die Patenterteilung: **01.11.2017**
(21) Anmeldenummer: 11723032.6
(22) Anmeldetag: 25.05.2011
(51) Int. Cl.: H01L 33/48, H01L 33/62, H01L 33/54

(54) **HERSTELLUNG EINES OBERFLÄCHENMONTIERBAREN OPTOELEKTRONISCHEN BAUELEMENTS**
METHOD FOR PRODUCING A SURFACE-MOUNTABLE OPTOELECTRONIC COMPONENT
PROCÉDÉ DE FABRICATION D'UN COMPOSANT OPTOÉLECTRONIQUE POUVANT ÊTRE MONTÉ EN SURFACE

(30) Priorität: 15.06.2010 DE 102010023815
(43) Veröffentlichungstag der Anmeldung: 24.04.2013
(73) Patentinhaber: OSRAM Opto Semiconductors GmbH, 93055 Regensburg (DE)
(72) Erfinder: ZITZLSPERGER, Michael, 93047 Regensburg (DE); JÄGER, Harald, 93049 Regensburg (DE)
(74) Vertreter: Epping - Hermann - Fischer
(86) Internationale Anmeldenummer: PCT/EP2011/058583
(87) Internationale Veröffentlichungsnummer: WO 2011/157522

(56) Entgegenhaltungen:
- EP-A2- 1 253 650
- WO-A2-97/12386
- DE-A1- 10 229 067
- DE-A1-102005 041 064
- DE-A1-102008 038 748
- DE-A1-102008 053 489
- US-A1- 2004 140 764

## Beschreibung

Es wird ein oberflächenmontierbares optoelektronisches Bauelement sowie ein Verfahren zur Herstellung eines solchen Bauelements angegeben.

Bei der Herstellung von oberflächenmontierbaren Halbleiterbauelementen (surface mounted device, SMD), beispielsweise Leuchtdioden, können die optoelektronischen Halbleiterchips in einem vorgefertigten Gehäuse mit einem metallischen Leiterrahmen platziert werden. Die Montage der Halbleiterchips erfolgt typischerweise durch Kleben mit Silberleitkleber, was die Wärmeableitung von Verlustwärme und damit die Leistungsfähigkeit der LEDs begrenzt.

In der Druckschrift WO 97/12386 A2 ist ein Strahlung aussendendes und/oder empfangendes Halbleiterbauelement angegeben, bei dem ein Strahlung aussendender und/oder empfangender Halbleiterchip auf einem Chipträgerteil eines Leiterrahmens befestigt ist.

Aus der Druckschrift DE 10 2008 053 489 A1 ist ein Halbleiterbauelement bekannt, bei dem ein Trägerkörper eine Verbindungsschicht und eine Leiterschicht aufweist, wobei diese Schichten miteinander über ihre Hauptflächen verbunden sind.

Die Druckschrift EP 1 253 650 A2 beschreibt eine Lichtquelle, die ein planares Substrat mit einer zentral positionierten Apertur aufweist. Eine metallische Schicht auf einem Boden der Apertur liefert einen thermischen Pfad für die von einer Licht emittierenden Diode erzeugte Strahlung.

Die Druckschrift US 2004/0140764 A1 befasst sich mit einem Licht emittierenden Diodenbauteil, welches ein Kupfersubstrat mit mehreren Licht emittierenden Bereichen, mehreren Chips und einer Verkapselung aufweist.

Eine Aufgabe der vorliegenden Anmeldung ist es, ein Verfahren anzugeben, mit dem ein oberflächenmontierbares Bauelement, bei dem die im Betrieb erzeugte Verlustwärme effizient abgeführt werden kann, einfach, kostengünstig und zuverlässig hergestellt werden kann.

Diese Aufgabe wird durch ein Herstellungsverfahren mit den Merkmalen des unabhängigen Patentanspruchs 1 gelöst. Ausgestaltungen und Weiterbildungen sind Gegenstand der abhängigen Patentansprüche.

Gemäß einer Ausführungsform weist ein durch das Verfahren hergestelltes oberflächenmontierbares optoelektronisches Bauelement eine Strahlungsdurchtrittsfläche, einen optoelektronischen Halbleiterchip und einen Chipträger auf.

In dem Chipträger ist eine Kavität ausgebildet, in der der Halbleiterchip angeordnet ist. Ein Formkörper umgibt den Chipträger zumindest bereichsweise. Der Chipträger erstreckt sich in einer senkrecht zur Strahlungsdurchtrittsfläche verlaufenden vertikalen Richtung vollständig durch den Formkörper hindurch.

Die im Betrieb des Halbleiterchips erzeugte Verlustwärme kann somit vom Halbleiterchip direkt über den Chipträger aus dem Bauelement abgeführt werden. In vertikaler Richtung erstreckt sich der Chipträger zwischen einer der Strahlungsdurchtrittsfläche zugewandten Oberseite und einer Unterseite. Die Kavität ist zweckmäßigerweise in der Oberseite des Chipträgers ausgebildet.

Der Halbleiterchip ist vorzugsweise stoffschlüssig mit dem Chipträger verbunden. Bei einer stoffschlüssigen Verbindung werden die, bevorzugt vorgefertigten, Verbindungspartner mittels atomarer und/oder molekularer Kräfte zusammengehalten. Eine stoffschlüssige Verbindung kann beispielsweise mittels eines Verbindungsmittels, etwa eines Klebemittels oder eines Lots, erzielt werden. In der Regel geht eine Trennung der Verbindung mit einer Zerstörung des Verbindungsmittels, etwa einer Verbindungsschicht, und/oder zumindest eines der Verbindungspartner einher.

Vorzugsweise ist zwischen dem Chipträger und dem Halbleiterchip eine Lotschicht als Verbindungsschicht ausgebildet. Eine Lotschicht zeichnet sich durch eine besonders hohe Wärmeleitfähigkeit aus, so dass der thermische Widerstand zwischen Halbleiterchip und Chipträger verringert und somit die Wärmeableitung aus dem Halbleiterchip weitergehend verbessert ist.

Der Formkörper enthält vorzugsweise ein Kunststoffmaterial oder besteht aus einem Kunststoffmaterial. Ein solches Material ist bei der Herstellung des Bauelements einfach, zuverlässig und kostengünstig an den Chipträger anformbar.

Der Halbleiterchip ist vorzugsweise vollständig innerhalb der Kavität angeordnet. Das heißt, der Halbleiterchip ragt vorzugsweise nicht über die Oberseite des Chipträgers hinaus.

Zusätzlich zu dem optoelektronischen Halbleiterchip kann das Bauelement auch einen weiteren Halbleiterchip, insbesondere einen elektronischen oder optoelektronischen Halbleiterchip aufweisen. Der weitere Halbleiterchip kann in der Kavität oder in einer weiteren Kavität angeordnet sein.

In einer bevorzugten Ausgestaltung ist der Formkörper in vertikaler Richtung vollständig zwischen einer durch die Oberseite des Chipträgers vorgegebenen ersten Hauptebene und einer durch die Unterseite des Chipträgers vorgegebenen zweiten Hauptebene ausgebildet. Mit anderen Worten ist eine maximale Dicke des Formkörpers kleiner oder gleich der Dicke des Chipträgers. Unter "Dicke" wird in diesem Zusammenhang die Ausdehnung in vertikaler Richtung verstanden.

Weiterhin bevorzugt schließt der Chipträger in vertikaler Richtung zumindest in einem an den Chipträger angrenzenden Bereich mit der Unterseite des Chipträgers und/oder mit der Oberseite des Chipträgers bündig ab. Weitergehend kann der Formkörper den Chipträger in lateraler Richtung vollständig umlaufen und insbesondere im gesamten Bereich um den Chipträger bündig mit der Oberseite und der Unterseite des Chipträgers abschließen.

In einer bevorzugten Ausgestaltung ist in dem Formkörper eine Kontaktstruktur angeordnet. Die Kontaktstruktur erstreckt sich vorzugsweise in vertikaler Richtung vollständig durch den Formkörper hindurch. Die Kontaktstruktur ist zweckmäßigerweise über eine Verbindungsleitung, etwa eine Drahtbond-Verbindung, mit dem Halbleiterchip elektrisch leitend verbunden. Mittels der Kontaktstruktur ist der Halbleiterchip von der der Strahlungsaustrittsfläche abgewandten Seite her extern elektrisch kontaktierbar.

Die Verbindungsleitung verläuft vorzugsweise bereichsweise zwischen der ersten Hauptebene und der Strahlungsdurchtrittsfläche. In vertikaler Richtung überragt die Verbindungsleitung also bereichsweise den Formkörper und weiterhin auch den Chipträger. Hierbei überbrückt die Verbindungsleitung in Aufsicht auf das Bauelement einen lateralen Abstand zwischen dem Chipträger und der Kontaktstruktur.

In einer weiteren bevorzugten Ausgestaltung bildet der Chipträger einen ersten Kontakt, über den der Halbleiterchip extern elektrisch kontaktierbar ist. In diesem Fall kann die Kontaktstruktur einen weiteren Kontakt bilden, wobei der erste Kontakt und der weitere Kontakt vorzugsweise auf der der Strahlungsdurchtrittsfläche abgewandten Seite des Bauelements angeordnet sind.

Alternativ ist auch denkbar, dass der Chipträger nicht zur externen elektrischen Kontaktierung vorgesehen ist, sondern insbesondere der Wärmeableitung dient. In diesem Fall weist das Bauelement zweckmäßigerweise zumindest eine weitere Kontaktstruktur auf, so dass das Bauelement zumindest zwei externe elektrische Kontakte zur Verfügung stellt.

In einer bevorzugten Ausgestaltung weist eine Bodenfläche der Kavität eine erste Beschichtung auf. Die erste Beschichtung ist insbesondere dafür vorgesehen, eine Lötverbindung mit dem optoelektronischen Halbleiterchip zu vereinfachen. Mittels der ersten Beschichtung kann somit das Herstellen einer Verbindung zwischen dem Chipträger und dem Halbleiterchip mit einem geringen Wärmewiderstand vereinfacht werden. Vorzugsweise besteht die erste Beschichtung aus Gold oder aus einer metallischen Legierung, die Gold enthält.

In einer weiteren bevorzugten Ausgestaltung ist eine Seitenfläche der Kavität für im Betrieb des optoelektronischen Bauelements vom optoelektronischen Halbleiterchip zu erzeugende und/oder zu empfangende Strahlung reflektierend ausgebildet.

Insbesondere kann die Seitenfläche eine zweite Beschichtung aufweisen. Die zweite Beschichtung enthält vorzugsweise ein Metall oder eine metallische Legierung. Im sichtbaren Spektralbereich und im ultravioletten Spektralbereich zeichnen sich beispielsweise Silber, Aluminium, Rhodium und Chrom durch eine hohe Reflektivität aus. Im infraroten Spektralbereich eignet sich beispielsweise Gold für die zweite Beschichtung.

Alternativ oder ergänzend kann der Chipträger auch einen Kunststoff enthalten. Zur Steigerung der Reflektivität kann in den Kunststoff ein Füllstoff, etwa Titandioxid, eingebracht sein.

In einer bevorzugten Ausgestaltung ist der optoelektronische Halbleiterchip in eine Umhüllung eingebettet. Die Umhüllung dient der Verkapselung des Halbleiterchips und schützt diesen vor widrigen äußeren Einflüssen, beispielsweise Feuchtigkeit oder Staub. Vorzugsweise bedeckt die Umhüllung auch den Formkörper zumindest bereichsweise. In vertikaler Richtung erstreckt sich die Umhüllung weiterhin bevorzugt über die erste Hauptebene des Formkörpers hinaus in Richtung Strahlungsdurchtrittsfläche. Insbesondere kann die Strahlungsdurchtrittsfläche mittels der Umhüllung gebildet sein. Die Umhüllung kann beispielsweise zumindest bereichsweise linsenförmig, etwa in Aufsicht auf das Bauelement konvex gekrümmt, ausgebildet sein. Die Umhüllung ist zweckmäßigerweise für die im optoelektronischen Halbleiterchip zu erzeugende und/oder zu empfangende Strahlung transparent oder zumindest transluzent ausgebildet.

In einer bevorzugten Weiterbildung weist der Chipträger eine Verankerungsstruktur auf, an die die Umhüllung und/oder der Formkörper angeformt ist. Die Verankerungsstruktur ist dafür vorgesehen, ein Ablösen der Umhüllung und/oder des Formkörpers vom Chipträger dauerhaft zu verhindern oder zumindest zu erschweren.

Beispielsweise kann der Chipträger von der Strahlungsaustrittsfläche aus gesehen eine Hinterschneidung aufweisen.

Insbesondere eine Verankerungsstruktur für den Formkörper kann als eine Wulst ausgebildet sein, die den Chipträger in lateraler Richtung vollständig oder zumindest bereichsweise umläuft.

Eine Verankerungsstruktur für die Umhüllung kann insbesondere in der Kavität ausgebildet sein oder an die Kavität angrenzen.

In einer weiteren bevorzugten Ausgestaltung schließen die Umhüllung und der Formkörper zumindest in einer entlang der Strahlungsdurchtrittsfläche verlaufenden Richtung bündig ab. Vorzugsweise schließen die Umhüllung und der Formkörper über den gesamten Umfang des Bauelements bündig miteinander ab. Ein derartiges Bauelement ist bei der Herstellung mittels Durchtrennens von Umhüllung und Formkörper in einem gemeinsamen Fertigungsschritt besonders einfach aus einer Matrix von nebeneinander angeordneten Bauelementbereichen vereinzelbar.

Bei einem Verfahren zur Herstellung eines oberflächenmontierbaren optoelektronischen Bauelements wird gemäß einer Ausführungsform ein Chipträger bereitgestellt, bei dem in einer Oberseite eine Kavität ausgebildet ist. In der Kavität wird ein optoelektronischer Halbleiterchip angeordnet und zweckmäßigerweise befestigt. Der Chipträger wird auf einem Hilfsträger angeordnet. Der Hilfsträger mit dem Chipträger wird in einer Umformungsform angeordnet, wobei die Kavität mittels der Umformungsform und der Oberseite des Chipträgers dicht abgeschlossen ist. Die Umformungsform wird mit einer Formmasse befüllt, wobei die Formmasse außerhalb der Kavität zumindest bereichsweise an den Chipträger angeformt wird. Die Umformungsform wird entfernt. Der Hilfsträger wird entfernt.

Das Verfahren wird vorzugsweise in der angegebenen Reihenfolge der Herstellungsschritte durchgeführt. Es sind aber auch davon abweichende Reihenfolgen denkbar. Beispielsweise kann das Anordnen des Halbleiterchips in der Kavität auch erst nach dem Anformen der Formmasse an den Chipträger erfolgen.

Unter "dicht abgeschlossen" wird in diesem Zusammenhang verstanden, dass die Formmasse beim Befüllen der Umformungsform nicht in die Kavität des Chipträgers eindringt. Vorzugsweise grenzen der Chipträger und die Umformungsform in einem die Kavität umlaufenden Bereich unmittelbar aneinander an.

Mit dem beschriebenen Verfahren kann eine Mehrzahl von optoelektronischen Bauelementen gleichzeitig hergestellt werden. Die nebeneinander angeordneten Bauelemente können, insbesondere mittels Durchtrennens der Formmasse, etwa mittels Sägens, vereinzelt werden. Dies erfolgt zweckmäßigerweise nach dem Entfernen der Umformungsform.

Der Chipträger ist zweckmäßigerweise freitragend ausgebildet. Das heißt, der Chipträger kann, insbesondere zusammen mit dem bereits auf dem Chipträger montierten optoelektronischen Halbleiterchip, einfach und zuverlässig auf dem Hilfsträger platziert werden.

In einer bevorzugten Ausgestaltung ist auf dem Hilfsträger eine Kontaktstruktur ausgebildet. Die Kontaktstruktur wird vorzugsweise als ein Leiterrahmen bereit gestellt. Weiterhin bevorzugt ist die Kontaktstruktur auf dem Hilfsträger bereits vorgefertigt, insbesondere bevor der Chipträger auf dem Hilfsträger platziert wird.

In einer bevorzugten Weiterbildung ist die Kontaktstruktur in vertikaler Richtung strukturiert. Mittels dieser Strukturierung kann die Kontaktstruktur unterschiedliche Dicken aufweisen. Beim Anformen der Formmasse an die Kontaktstruktur kann dies eine verbesserte Verzahnung von Kontaktstruktur und Formkörper bewirken, wodurch die mechanische Stabilität des Bauelements verbessert wird.

Beim Befüllen der Umformungsform können die Kontaktstruktur und der Chipträger mittels der Formmasse für den Formkörper dauerhaft und stabil mechanisch miteinander verbunden werden.

Nach dem Entfernen der Umformungsform kann der Halbleiterchip mit einer Verbindungsleitung elektrisch leitend mit der Kontaktstruktur verbunden werden. Dies kann beispielsweise mittels eines Drahtbond-Verfahrens erfolgen.

In einer bevorzugten Ausgestaltung weist der Chipträger eine äußere Seitenfläche auf, die von einer Oberseite zu einer Unterseite des Chipträgers verläuft. Die äußere Seitenfläche wird von der Formmasse vorzugsweise vollständig umformt.

Der Formkörper wird vorzugsweise mittels Spritzgießens oder Spritzpressens hergestellt. Grundsätzlich eignen sich alle Herstellungsverfahren, mit denen die Umformungsform einfach und zuverlässig befüllt werden kann.

Nach dem Entfernen der Umformungsform wird der Halbleiterchip vorzugsweise mit einer Umhüllung versehen. Die Umhüllung kann den Formkörper zumindest bereichsweise, bevorzugt vollständig, bedecken. Bei der Vereinzelung der Bauelemente kann die Umhüllung zusammen mit dem Formkörper durchtrennt werden. So entsteht eine Mehrzahl von optoelektronischen Bauelementen, bei denen die Umhüllung und der Formkörper entlang einer Umrandung der Bauelement bündig miteinander abschließen.

Das beschriebene Verfahren ist zur Herstellung eines weiter oben beschriebenen optoelektronischen Bauelements besonders geeignet. Im Zusammenhang mit dem Bauelement ausgeführte Merkmale können daher auch für das Verfahren herangezogen werden und umgekehrt.

Weitere Merkmale, Ausgestaltungen und Zweckmäßigkeiten ergeben sich aus der folgenden Beschreibung der Beispiele und Ausführungsbeispiele in Verbindung mit den Figuren.

Es zeigen:
Die Figuren 1A und 1B ein erstes Beispiel für ein oberflächenmontierbares optoelektronisches Bauelement in schematischer Aufsicht (Figur 1B) und zugehöriger Schnittansicht (Figur 1A);
Figur 2 ein zweites Beispiel für ein oberflächenmontierbares optoelektronisches Bauelement in schematischer Schnittansicht;
die Figuren 3A bis 3F ein Ausführungsbeispiel für ein Verfahren zur Herstellung eines optoelektronischen Bauelements anhand von schematisch in Schnittansicht dargestellten Zwischenschritten; und
Figur 4 ein Ausführungsbeispiel für einen Bauelementverbund zur Herstellung eines optoelektronischen Bauelements.

Gleiche, gleichartige oder gleich wirkende Elemente sind in den Figuren mit denselben Bezugszeichen versehen.

Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

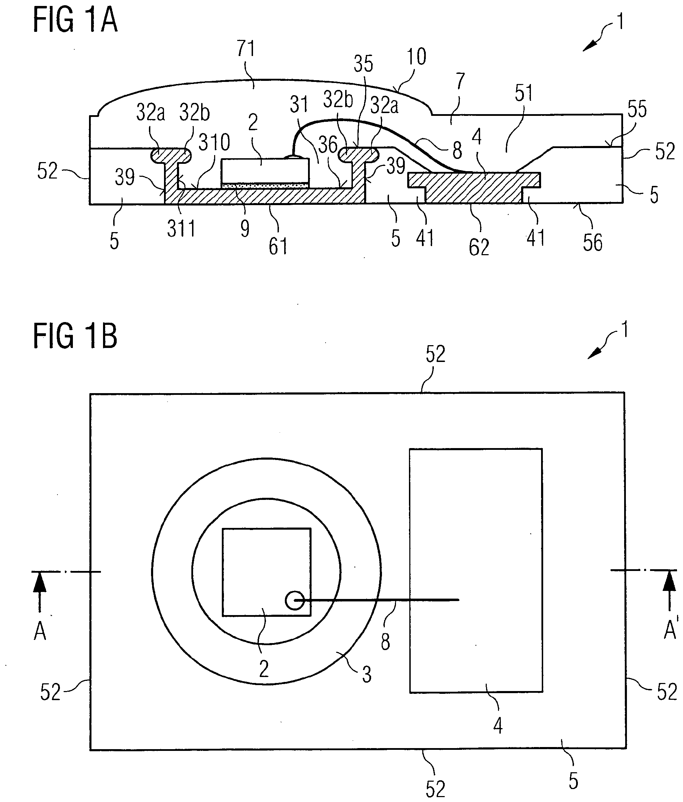

In den Figuren 1A und 1B ist in schematischer Darstellung ein erstes Beispiel für ein oberflächenmontierbares optoelektronisches Bauelement 1 in schematischer Aufsicht (Figur 1B) und zugehöriger schematischer Schnittansicht entlang der Linie A-A' (Figur 1A) dargestellt.

Das oberflächenmontierbare optoelektronische Bauelement 1 weist einen Halbleiterchip 2 auf, der in einer Kavität 31 eines Chipträgers 3 angeordnet ist. Der Halbleiterchip 2 ist mittels einer Verbindungsschicht 9 an einer Bodenflächen 310 des Chipträgers 3 mechanisch stabil verbunden.

Die Verbindungsschicht 9 ist vorzugsweise als eine Lotschicht ausgeführt und bewirkt, insbesondere im Vergleich zu einer Klebeverbindung, eine besonders effiziente thermische Anbindung des Halbleiterchips an den Chipträger 3.

Die Kavität ist in einer einer Strahlungsdurchtrittsfläche 10 des Bauelements zugewandten Oberseite 35 des Chipträgers 3 ausgebildet. Auf der der Oberseite gegenüberliegenden Unterseite 36 bildet der Chipträger 3 einen zur externen elektrischen Kontaktierung vorgesehenen ersten Kontakt 61.

In lateraler Richtung, also in einer senkrecht zur vertikalen Richtung verlaufenden Richtung, ist der Chipträger 3 von einem Formkörper 5 umgeben. In vertikaler Richtung, also senkrecht zur Strahlungsdurchtrittsfläche 10 und somit parallel zu einer Hauptstrahlungsdurchtrittsrichtung, schließt der Formkörper 5 bündig mit der Oberseite 35 und mit der Unterseite 36 ab. Der Formkörper 5 ist an eine äußere Seitenfläche 39 des Chipträgers 3 angeformt und bedeckt die äußere Seitenfläche vollständig.

In dem Formkörper 5 ist weiterhin eine Kontaktstruktur 4 angeordnet. Die Kontaktstruktur 4 bildet auf der der Strahlungsdurchtrittsfläche 10 abgewandten Seite einen extern zugänglich weiteren Kontakt 62. Die Kontaktstruktur 4 ist mittels einer Verbindungsleitung 8 in Form einer Drahtbond-Verbindung mit dem Halbleiterchip 2 elektrisch leitend verbunden. Im Betrieb des Halbleiterchips können über den ersten Kontakt 61 und den weiteren Kontakt 62 Ladungsträger in den Halbleiterchip injiziert werden oder von diesem abfließen.

In lateraler Richtung ist die Kontaktstruktur 4 von dem Chipträger 3 beabstandet. Eine mechanisch stabile Verbindung zwischen Chipträger und Kontaktstruktur erfolgt lediglich über den Formkörper 5.

Der laterale Abstand zwischen dem Chipträger 3 und der Kontaktstruktur 4 wird durch die Verbindungsleitung 8 überbrückt. Die Verbindungsleitung ragt über die Oberseite 35 des Chipträgers und verläuft im Bereich zwischen dem Chipträger und der Kontaktstruktur 4 zwischen der Oberseite und der Strahlungsdurchtrittsfläche 10. Auf eine zusätzliche Ausnehmung im Formkörper 50 für die Verbindungsleitung kann somit verzichtet werden.

Im Bereich der Kontaktstruktur 4 weist der Formkörper 5 eine Ausnehmung 51 auf, so dass die Kontaktstruktur auf der der Strahlungsdurchtrittsfläche zugewandten Seite zum Anschließen der Verbindungsleitung 8 zugänglich ist.

Die Kontaktstruktur 4 weist weiterhin eine umlaufende Hinterschneidung 41 auf, bei denen die Dicke der Kontaktstruktur geringer ist als im Bereich des zweiten Kontakts 62. Die Hinterschneidung dient einer verbesserten Verzahnung zwischen dem Formkörper 5 und der Kontaktstruktur.

Die Kontaktstruktur 4 erstreckt sich in vertikaler Richtung vollständig durch den Formkörper hindurch. Somit ist die Kontaktstruktur seitens der Strahlungsaustrittsfläche 10 innerhalb des Bauelements 1 und auf der der Strahlungsaustrittsfläche abgewandten Seite extern elektrisch kontaktierbar. In vertikaler Richtung ist die Dicke der Kontaktstruktur vorzugsweise geringer als die Dicke des Chipträgers 3. Auf diese Weise kann der Materialbedarf für die Kontaktstruktur verringert werden.

Der Chipträger 3 weist eine Verankerungsstruktur 32 mit einer äußeren Verankerungsstruktur 32a auf. Die äußere Verankerungsstruktur entläuft entlang der äußeren Seitenfläche 39 des Chipträgers und dient der Verankerung des Chipträgers 3 in dem Formkörper 5.

Weiterhin ist an einer Seitenfläche 311 der Kavität 31 eine innere Verankerungsstruktur 32b ausgebildet.

Das optoelektronische Bauelement 1 weist weiterhin eine Umhüllung 7 auf, die den Halbleiterchip 2 verkapselt. In der Umhüllung ist weiterhin die als Drahtbond-Verbindung ausgebildete Verbindungsleitung 8 ausgebildet. Die Umhüllung dient somit insbesondere dem Schutz des Halbleiterchips und der Verbindungsleitung vor mechanischen Beschädigungen und weiteren widrigen äußeren Einflüssen wie Feuchtigkeit oder Staub.

Mittels der inneren Verankerungsstruktur 32b kann die mechanische Stabilität der Verbindung der Umhüllung 7 mit dem Chipträger 3 verbessert werden. Die Gefahr einer Ablösung der Umhüllung kann somit weitestgehend verringert werden.

Der Formkörper 5 erstreckt sich in vertikaler Richtung zwischen einer ersten Hauptebene 55 und einer zweiten Hauptebene 56. Diese Hauptebenen sind jeweils durch die Oberseite 35 beziehungsweise die Unterseite 36 des Chipträgers 3 vorgegeben.

Die Verbindungsleitung 8 erstreckt sich in vertikaler Richtung bereichsweise zwischen der ersten Hauptebene 55 und der Strahlungsaustrittsfläche 10. Die Verbindungsleitung überragt somit die erste Hauptebene.

Die Strahlungsaustrittsfläche 10 ist mittels der Umhüllung 7 gebildet. Ein Bereich der Umhüllung ist als eine Linse 71 für die im optoelektronischen Halbleiterchip im Betrieb zu erzeugende und/oder zu detektierende Strahlung ausgebildet. Die Umhüllung 7 ist zweckmäßigerweise für die Strahlung transparent oder zumindest transluzent ausgebildet. Vorzugsweise enthält die Umhüllung ein Silikon, ein Epoxid oder eine Mischung aus Silikon und Epoxid oder besteht aus einem solchen Material oder einer Mischung aus einem solchen Material.

In der Umhüllung können weiterhin lichtstreuende oder reflektierende Partikel und/oder ein Lumineszenzkonversionsmaterial ausgebildet sein.

Das Material für den Formkörper 5 kann dagegen weitgehend unabhängig von seinen optischen Eigenschaften gewählt werden und insbesondere auch für die Strahlung absorbierend ausgebildet sein. Der Formkörper 5 enthält vorzugsweise einen Kunststoff oder besteht aus Kunststoff.

In lateraler Richtung ist der Formkörper 5 durch einen Rand 52 begrenzt. Entlang des Rands schließen der Formkörper 5 und die Umhüllung 7 bündig miteinander ab, vorzugsweise über den gesamten Umfang des Bauelements.

Der Chipträger 3 ist in diesem Beispiel aus einem elektrisch leitfähigen Material gebildet, vorzugsweise aus einem Metall, beispielsweise Kupfer, Aluminium, Silber, oder Gold, oder aus einer metallischen Legierung mit zumindest einem solchen Metall.

Von dem beschriebenen Beispiel abweichend kann der Chipträger 3 aber auch elektrisch isolierend ausgebildet sein. In diesem Fall weist das Bauelement 1 zweckmäßigerweise eine weitere Kontaktstruktur auf, so dass die Kontaktstruktur 4 und die weitere Kontaktstruktur (nicht explizit dargestellt) zwei externe Kontakte für das Bauelement 1 bilden.

Für den Fall eines elektrisch isolierenden Chipträgers 3 kann beispielsweise eine Keramik, etwa Aluminiumnitrid oder Bornitrid oder ein Kunststoff, etwa ein Silikon, Anwendung finden. Zur Steigerung der Reflexion kann der Kunststoff gefüllt sein, beispielsweise mit Titandioxid. Eine Keramik kann sich durch eine hohe thermische Leitfähigkeit auszeichnen.

Der Halbleiterchip 2 ist vollständig innerhalb der Kavität 31 des Chipträgers 3 ausgebildet. Er ragt also nicht über die Oberseite 35 des Chipträgers hinaus.

Der optoelektronische Halbleiterchip 2 kann beispielsweise als ein LED-Chip, als ein Laserchip oder ein Strahlungsdetektorchip ausgebildet sein.

Vorzugsweise enthält der Halbleiterchip ein III-V-Halbleitermaterial. III-V-Halbleitermaterialien sind zur Strahlungserzeugung im ultravioletten (Alₓ In_{y} Ga_{1-x-y} N) über den sichtbaren (Alₓ In_{y} Ga_{1-x-y} N, insbesondere für blaue bis grüne Strahlung, oder Alₓ In_{y} Ga_{1-x-y} P, insbesondere für gelbe bis rote Strahlung) bis in den infraroten (Alₓ In_{y} Ga_{1-x-y} As) Spektralbereich besonders geeignet. Hierbei gilt jeweils 0 ≤ x ≤ 1, 0 ≤ y ≤ 1 und x + y ≤ 1, insbesondere mit x ≠ 1, y ≠ 1, x ≠ 0 und/oder y ≠ 0. Mit III-V-Halbleitermaterialien, insbesondere aus den genannten Materialsystemen, können weiterhin bei der Strahlungserzeugung hohe interne Quanteneffizienzen erzielt werden.

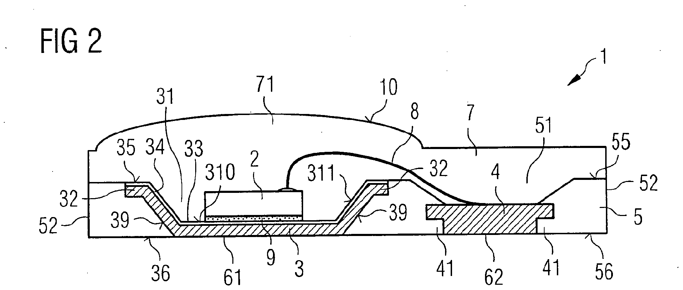

Ein zweites Beispiel für ein oberflächenmontierbares optoelektronisches Bauelement ist in Figur 2 schematisch in Schnittansicht dargestellt. Dieses zweite Beispiel entspricht im Wesentlichen dem im Zusammenhang mit Figur 1 beschriebenen ersten Beispiel.

Im Unterschied hierzu ist die Kavität 31 des Chipträgers 3 reflektorartig ausgebildet. Eine Seitenfläche 311 der Kavität 31 weist vorzugsweise einen Winkel von einschließlich 20° bis einschließlich 70° zur Bodenfläche 310 der Kavität auf.

Der Chipträger 3 ist als ein beschichteter Körper, beispielsweise als ein beschichteter Kupfer-Körper, ausgeführt.

Die Bodenfläche 310 ist mittels einer ersten Beschichtung 33 gebildet. Die erste Beschichtung ist vorzugsweise für eine vereinfachte Herstellung einer Lotverbindung zwischen dem Chipträger 3 und dem Halbleiterchip 2 ausgebildet. Vorzugsweise besteht die erste Beschichtung aus Gold oder einer Gold-haltigen Legierung.

Die Seitenfläche 311 ist mittels einer zweiten Beschichtung 34 gebildet. Die zweite Beschichtung 34 weist vorzugsweise für eine im Halbleiterchip im Betrieb zu erzeugende und/oder zu detektierende Strahlung eine hohe Reflektivität, vorzugsweise 60 % oder mehr, auf. Vorzugsweise enthält die zweite Beschichtung ein Metall oder eine metallische Legierung. Beispielsweise zeichnen sich Silber, Aluminium, Rhodium oder Chrom durch eine hohe Reflektivität im sichtbaren und im ultravioletten Spektralbereich aus. Gold eignet sich insbesondere für Strahlung im infraroten Spektralbereich.

Die beschriebene mehrschichtige Ausgestaltung des Chipträgers 3 kann auch bei dem im Zusammenhang mit Figur 1 beschriebenen ersten Beispiel Anwendung finden.

Die Verankerungsstruktur 32 dient in diesem Beispiel lediglich der Verankerung des Chipträgers 3 im Formkörper 5. Wie im Zusammenhang mit Figur 1A beschrieben kann jedoch vom beschriebenen Beispiel abweichend auch für die Umhüllung 7 eine Verankerungsstruktur vorgesehen sein.

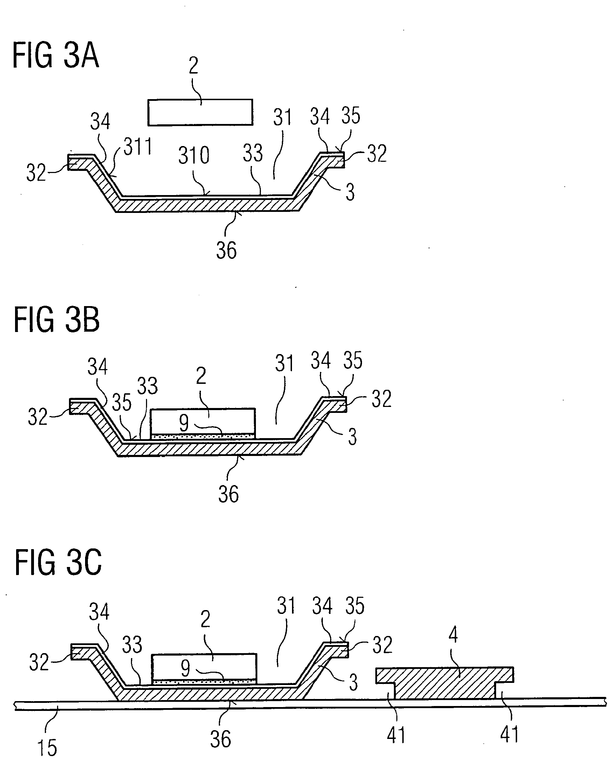

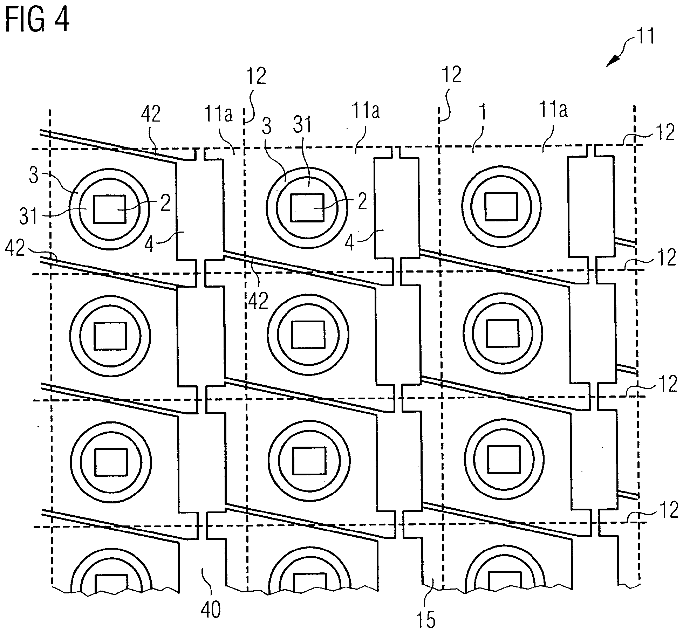

Ein Ausführungsbeispiel für ein Verfahren zur Herstellung eines oberflächenmontierbaren optoelektronischen Bauelements ist in den Figuren 3A bis 3F anhand von schematisch in Schnittansicht dargestellten Zwischenschritten gezeigt. Zur verbesserten Darstellung ist in den Figuren 3A bis 3F lediglich ein Teil eines Bauelementverbunds dargestellt, aus dem bei der Herstellung ein Bauelement hervorgeht. Eine Aufsicht auf einen Bauelementverbund 11 vor der Vereinzelung in Bauelemente ist in Figur 4 in Aufsicht dargestellt.

Wie in Figur 3A gezeigt, wird ein Chipträger 3 bereitgestellt, der eine Oberseite 35 und eine Unterseite 36 aufweist. Seitens der Oberseite 35 ist eine Kavität 31 in dem Chipträger 3 ausgebildet. Weiterhin wird ein optoelektronischer Halbleiterchip 2 bereitgestellt. Der optoelektronische Halbleiterchip 2 wird in der Kavität 31 des Chipträgers 3 mittels einer Verbindungsschicht 9 elektrisch leitend und mechanisch stabil verbunden. Wie im Zusammenhang mit Figur 2 beschrieben, weist der Chipträger 3 zumindest im Bereich einer Bodenfläche 310 der Kavität 31 eine Beschichtung auf, so dass der Halbleiterchip 2 auf den Chipträger gelötet werden kann.
Der Chipträger 3 mit dem Halbleiterchip 2 wird auf einem Hilfsträger 15 angeordnet. Als Hilfsträger eignet sich beispielsweise eine Kunststofffolie, die vorzugsweise zumindest auf der dem Chipträger 3 zugewandten Seite adhäsive Eigenschaften hat.

Auf dem Hilfsträger 15 ist weiterhin eine Kontaktstruktur 4 angeordnet. Die Kontaktstruktur ist vorzugsweise bereits vor der Befestigung des Halbleiterchips 2 an dem Hilfsträger auf dem Hilfsträger ausgebildet.

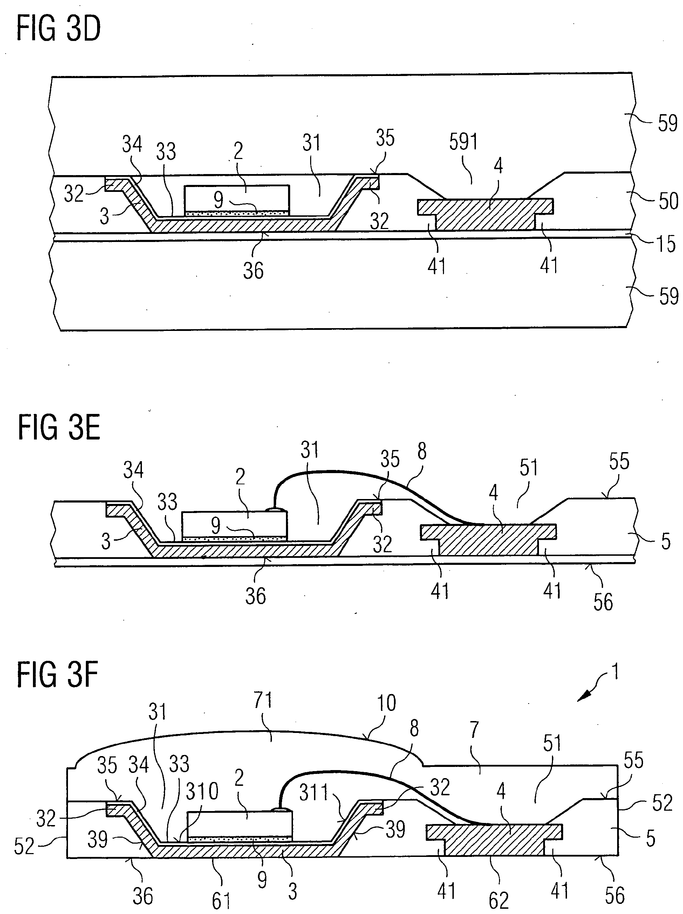

Der Hilfsträger mit dem Chipträger 3 und der Kontaktstruktur 4 wird in einer Umformungsform 59 angeordnet (Figur 3D). Der Chipträger 3 und die Umformungsform 59 sind derart aneinander angepasst, dass die Oberseite des Chipträgers 35 und die Umformungsform 59 unmittelbar aneinander angrenzen und die Kavität 31 dicht umschließen. Beim Befüllen der Umformungsform 59 mit einer Formmasse 50 wird die Formmasse somit an den Chipträger 3 angeformt, ohne in die Kavität 31 einzudringen.

Im Bereich der Kontaktstruktur 4 weist die Umformungsform 59 eine Erhebung 591 auf. Die Erhebung 591 grenzt unmittelbar an die Kontaktstruktur 4 an, so dass die Kontaktstruktur 4 im Bereich der Erhebung frei von dem Material für die Formmasse bleibt. Das Befüllen der Umformungsform 59 erfolgt vorzugsweise mittels eines Gieß- oder Spritzverfahrens, beispielsweise mittels Spritzgießens oder Spritzpressens.

Nach einem Aushärten oder zumindest einem Anhärten der Formmasse 50 kann die Umformungsform 59 entfernt werden. Mittels des so entstandenen Formkörpers 5 ist nun die Kontaktstruktur 4 mit dem Chipträger 3 mechanisch stabil verbunden.

Nach dem Entfernen der Umformungsform kann auch der Hilfsträger 15 entfernt werden.

Der Halbleiterchip 2 und die Kontaktstruktur 4 werden mit einer Verbindungsleitung 8, beispielsweise einer Drahtbond-Verbindung elektrisch leitend miteinander verbunden (Figur 3E).

Nach dem Herstellen der elektrischen Verbindung kann der Halbleiterchip 2 und der Formkörper 5 mit einer Umhüllung 7 versehen werden. Die Umhüllung kann mittels eines weiteren Spritzgussverfahrens oder eines Spritzpressverfahrens hergestellt werden.

Die Umhüllung 7 ist vorzugsweise derart ausgebildet, dass sie den Halbleiterchip und die Verbindungsleitung 8 vollständig bedeckt. Weiterhin ist vorzugsweise der gesamte Formkörper 5 von der Umhüllung bedeckt.

Nach dem Ausbilden der Umhüllung kann der Bauelementverbund 11 mittels Durchtrennens des Formkörpers 5 und der Umhüllung 7, beispielsweise mittels Durchsägens, in einzelne Bauelemente vereinzelt werden.

Das Verfahren wurde exemplarisch anhand der Herstellung eines Bauelements beschrieben, das wie im Zusammenhang mit Figur 2 beschrieben ausgeführt ist (Figur 3F). Selbstverständlich eignet sich das Verfahren auch für die Herstellung eines Bauelements gemäß dem anhand der Figuren 1A und 1B beschriebenen ersten Ausführungsbeispiel.
In Figur 4 ist ein Bauelementverbund 11 vor der Vereinzelung in Bauelemente in Aufsicht schematisch dargestellt.

Auf dem Hilfsträger 15 ist ein Kontaktstrukturverbund 40 ausgebildet. In dem Kontaktstrukturverbund sind die einzelnen Kontaktstrukturen 4 für die späteren Bauelemente mittels Stegen 42 miteinander verbunden. Der Kontaktstrukturverbund bildet somit einen zusammenhängenden Verbund für die Kontaktstrukturen 4. Der Kontaktstrukturverbund kann beispielsweise als ein Blech für einen Leiterrahmen ausgebildet sein. Das Blech kann beispielsweise gestanzt, geprägt oder geätzt sein. Insbesondere kann das Blech Kupfer enthalten oder aus Kupfer bestehen. Auch ein Verbundmaterial, etwa ein so genanntes "flex substrate", oder eine starre oder flexible gedruckte Leiterplatte (printed circuit board, PCB) kann Anwendung finden.

Beim Vereinzeln des Bauelementverbunds 11 werden die einzelnen Bauelementbereiche 11a mit jeweils zumindest einem Halbleiterchip 2, einem Chipträger 3 und einer Kontaktstruktur 4 entlang der gestrichelt dargestellten Trennlinien 12 vereinzelt.

Bei dem beschriebenen Verfahren können die optoelektronischen Halbleiterchips 2 bereits vor dem Ausbilden des Formkörpers 5 an den Chipträgern 3 befestigt werden. Von dem beschriebenen Ausführungsbeispiel abweichend ist jedoch auch denkbar, die Halbleiterchips erst nach dem Anformen des Formkörpers 5 an den Chipträger 3 in dem Chipträger 3 zu befestigen.

In beiden Fällen kann die Herstellung der elektrisch leitenden Verbindung zwischen dem Halbleiterchip 2 und dem Chipträger 3 mittels einer Lotverbindung erfolgen. Zur Vereinfachung der Lotverbindung ist es bereits ausreichend, lediglich die Bodenfläche 310 der Kavität 31 des Chipträgers 3 mit einer Beschichtung zu versehen.

Die Kontaktstruktur 4 ist dagegen nicht für eine Lotverbindung vorgesehen und muss deshalb keine besonderen Anforderungen hinsichtlich einer Verbindbarkeit mit einem Lot erfüllen. Somit kann der Halbleiterchip 2 mittels einer Lotverbindung montiert werden, ohne dass eine großflächige Vergoldung eines Leiterrahmens erfolgen muss. Vielmehr reicht es aus, lediglich die vergleichsweise kleine Fläche des Chipträgers 3 beziehungsweise dessen Bodenfläche mit einer solchen Beschichtung zu versehen. Dadurch können bei der Herstellung Ressourcen und somit Kosten eingespart werden, ohne die Zuverlässigkeit des Herstellungsverfahrens zu beeinträchtigen.

Die Erfindung ist nicht durch die Beschreibung anhand der Ausführungsbeispiele beschränkt.

## Patentansprüche

1. Verfahren zur Herstellung eines oberflächenmontierbaren optoelektronischen Bauelements (1) mit den Schritten:
a) Bereitstellen eines Chipträgers (3), bei dem in einer Oberseite (35) eine Kavität (31) ausgebildet ist;
b) Anordnen eines optoelektronischen Halbleiterchips in der Kavität (31);
c) Anordnen des Chipträgers (3) auf einem Hilfsträger (15);
d) Anordnen des Hilfsträgers (15) mit dem Chipträger (3) in einer Umformungsform (59), wobei die Kavität (31) mittels der Umformungsform (59) und der Oberseite (35) des Chipträgers (3) dicht abgeschlossen ist;
e)Befüllen der Umformungsform (59) mit einer Formmasse (50), wobei die Formmasse (50) außerhalb der Kavität (31) zumindest bereichsweise an den Chipträger (3) angeformt wird;
f) Entfernen der Umformungsform (59); und
g) Entfernen des Hilfsträgers (15).

2. Verfahren nach Anspruch 1,
bei dem auf dem Hilfsträger eine Kontaktstruktur (4) ausgebildet ist und der Chipträger und die Kontaktstruktur in Schritt e) mittels des Formkörpers mechanisch miteinander verbunden werden.

3. Verfahren nach Anspruch 2,
bei dem die Umformungsform eine Erhebung (591) aufweist, wobei die Erhebung unmittelbar an die Kontaktstruktur angrenzt, sodass die Kontaktstruktur im Bereich der Erhebung frei von Material für die Formmasse bleibt.

4. Verfahren nach Anspruch 2 oder 3,
bei dem der Chipträger einen ersten Kontakt (61) und die Kontaktstruktur einen weiteren Kontakt (62) bilden, wobei der erste Kontakt und der weitere Kontakt auf einer einer Strahlungsaustrittsfläche abgewandten Seite des Bauelements angeordnet werden.

5. Verfahren nach einem der vorhergehenden Ansprüche,
bei dem der Chipträger eine äußere Seitenfläche (39) aufweist, die von der Oberseite (35) zu einer Unterseite (36) des Chipträgers verläuft, wobei die äußere Seitenfläche vollständig von der Formmasse umformt wird.

6. Verfahren nach einem der vorhergehenden Ansprüche, bei dem der Formkörper mittels Spritzgießens oder Spritzpressens hergestellt wird.

7. Verfahren nach einem der vorhergehenden Ansprüche, bei dem eine Seitenfläche (311) der Kavität für im Betrieb des optoelektronischen Bauelements vom optoelektronischen Halbleiterchip zu erzeugende und/oder zu empfangende Strahlung reflektierend ausgebildet wird.

8. Verfahren nach einem der vorhergehenden Ansprüche,
bei dem auf eine Bodenfläche (310) der Kavität eine erste Beschichtung und auf die Seitenfläche der Kavität eine zweite Beschichtung aufgebracht werden, wobei die erste Beschichtung Gold enthält und die zweite Beschichtung Silber, Aluminium, Rhodium oder Chrom enthält.

9. Verfahren nach einem der vorhergehenden Ansprüche,
bei dem der Chipträger eine Verankerungsstruktur (32, 32a, 32b) aufweist, an die der Formkörper angeformt wird.

10. Verfahren nach einem der vorhergehenden Ansprüche, bei dem der Halbleiterchip nach Schritt e) mit einer Umhüllung (7) versehen wird, wobei die Umhüllung den Formkörper vollständig überdeckt.

11. Verfahren nach Anspruch 10,
bei dem der Chipträger eine Verankerungsstruktur (32, 32a, 32b) aufweist, an die die Umhüllung angeformt wird.

12. Verfahren nach Anspruch 10 oder 11,
bei dem die Umhüllung und der Formkörper in einem gemeinsamen Fertigungsschritt durchtrennt werden, so dass die Umhüllung und der Formkörper zumindest in einer entlang einer Strahlungsdurchtrittsfläche verlaufenden Richtung bündig abschließen.

## Claims

1. A method for producing a surface-mountable component (1), having the steps:
a) providing a chip carrier (3), in the top (35) of which a cavity (31) is formed;
b) arranging an optoelectronic semiconductor chip in the cavity (31);
c) arranging the chip carrier (3) on an auxiliary carrier (15) ;
d) arranging the auxiliary carrier (15) with the chip carrier (3) in a forming mould (59), wherein the cavity (31) is closed hermetically by means of the forming mould (59) and the top (35) of the chip carrier (3);
e) filling the forming mould (59) with a moulding composition (50), wherein the moulding composition (50) is moulded at least in places onto the chip carrier (3) outside the cavity (31) ;
f) removing the forming mould (59); and
g) removing the auxiliary carrier (15).

2. The method according to claim 1,
in which a contact structure (4) is provided on the auxiliary carrier and the chip carrier and the contact structure are joined together mechanically in step e) by means of the moulding.

3. The method according to claim 2,
in which the forming mould comprises a projection (591), wherein the projection directly adjoins the contact structure, such that the contact structure remains free of the moulding composition in the region of the projection.

4. The method according to claim 2 or 3,
in which the chip carrier forms a first contact (61) and the contact structure forms a further contact (62), wherein the first contact and the further contact are arranged on a side of the component remote from a radiation exit face.

5. The method according to any of the preceding claims,
in which the chip carrier comprises an outer side face (39), which extends from the top (35) to the bottom (36) of the chip carrier, wherein the outer side face is completely surrounded by the moulding composition.

6. The method according to any of the preceding claims,
in which the moulding is produced by means of injection moulding or transfer moulding.

7. The method according to any of the preceding claims,
in which a side face (311) of the cavity is configured to be reflective to radiation to be generated and/or received by the optoelectronic semiconductor chip during operation of the optoelectronic component.

8. The method according to any of the preceding claims,
in which a first coating is formed on a base surface (310) of the cavity and a second coating is formed on the side face of the cavity, wherein the first coating contains gold and the second coating contains silver, aluminium, rhodium or chromium.

9. The method according to any of the preceding claims,
in which the chip carrier comprises an anchoring structure (32, 32a, 32b), onto which the moulding is moulded.

10. The method according to any of the preceding claims,
in which after step e) the semiconductor chip is provided with a covering (7), wherein the covering completely covers the moulding.

11. The method according to claim 10,
in which the chip carrier comprises an anchoring structure (32, 32a, 32b), onto which the covering is moulded.

12. The method according to claim 10 or 11,
in which the covering and the moulding are severed in a joint manufacturing step, so that the covering and the moulding terminate flush at least in a direction extending along the radiation passage face.

## Revendications

1. Procédé pour la fabrication d'un élément optoélectronique (1) pouvant être monté en surface, présentant les étapes suivantes :
a) mise à disposition d'un support (3) de puce, dans lequel une cavité (31) est réalisée dans une face supérieure (35) ;
b) disposition d'une puce à semi-conducteur optoélectronique dans la cavité (31) ;
c) disposition du support (3) de puce sur un support auxiliaire (15) ;
d) disposition du support auxiliaire (15) avec le support (3) de puce dans un moule (59) de formage, la cavité (31) étant fermée de manière étanche à l'aide du moule (59) de formage et de la face supérieure (35) du support (3) de puce ;
e) remplissage du moule (59) de formage par une masse de moulage (50), la masse de moulage (50) étant moulée au moins en partie sur le support (3) de puce à l'extérieur de la cavité (31) ;
f) retrait du moule (59) de formage ; et
g) retrait du support auxiliaire (15).

2. Procédé selon la revendication 1,
dans lequel une structure de contact (4) est réalisée sur le support auxiliaire et le support de puce et la structure de contact sont reliés mécaniquement l'un à l'autre dans l'étape e) au moyen du corps moulé.

3. Procédé selon la revendication 2,
dans lequel le moule de formage présente une élévation (591), l'élévation étant immédiatement adjacente à la structure de contact de telle sorte que la structure de contact reste exempte de matériau pour la masse de moulage dans la zone de l'élévation.

4. Procédé selon la revendication 2 ou 3,
dans lequel le support de puce forme un premier contact (61) et la structure de contact forme un autre contact (62), le premier et l'autre contact étant disposés sur une face opposée à la surface de sortie du rayonnement de l'élément.

5. Procédé selon l'une quelconque des revendications précédentes,
dans lequel le support de puce présente une surface latérale externe (39) qui s'étend de la face supérieure (35) vers une face inférieure (36) du support de puce, la surface latérale externe étant formée complètement par la masse de moulage.

6. Procédé selon l'une quelconque des revendications précédentes,
dans lequel le corps moulé est réalisé par moulage par injection ou moulage à injection sous basse pression.

7. Procédé selon l'une quelconque des revendications précédentes,
dans lequel une face latérale (311) de la cavité est conçue de manière réfléchissante pour un rayonnement à générer et/ou à recevoir par la puce à semi-conducteur optoélectronique lors du fonctionnement de l'élément optoélectronique.

8. Procédé selon l'une quelconque des revendications précédentes,
dans lequel un premier revêtement est appliqué sur une surface de fond (310) de la cavité et un deuxième revêtement est appliqué sur la surface latérale de la cavité, le premier revêtement contenant de l'or et le deuxième revêtement contenant de l'argent, de l'aluminium, du rhodium ou du chrome.

9. Procédé selon l'une quelconque des revendications précédentes,
dans lequel le support de puce présente une structure d'ancrage (32, 32a, 32b) sur laquelle est moulé le corps moulé.

10. Procédé selon l'une quelconque des revendications précédentes,
dans lequel la puce à semi-conducteur est pourvue, après l'étape e), d'une enveloppe (7), l'enveloppe recouvrant complètement le corps moulé.

11. Procédé selon la revendication 10,
dans lequel le support de puce présente une structure d'ancrage (32, 32a, 32b) sur laquelle est moulée l'enveloppe.

12. Procédé selon la revendication 10 ou 11,
dans lequel l'enveloppe et le corps moulé sont sectionnés dans une étape de fabrication commune, de telle sorte que l'enveloppe et le corps moulé se terminent de manière affleurante au moins dans une direction s'étendant le long d'une surface de passage du rayonnement.
